(19) Europäisches Patentamt
European Patent Office
Office européen des brevets

(11) **EP 3 559 750 B1**

(12) **EUROPÄISCHE PATENTSCHRIFT**

(45) Veröffentlichungstag und Bekanntmachung des Hinweises auf die Patenterteilung:
**10.03.2021 Patentblatt 2021/10**

(21) Anmeldenummer: **17816592.4**

(22) Anmeldetag: **01.12.2017**

(51) Int Cl.:
*G03F 7/20* (2006.01)  *G06N 99/00* (2019.01)

(86) Internationale Anmeldenummer:
**PCT/EP2017/081166**

(87) Internationale Veröffentlichungsnummer:
**WO 2018/114287 (28.06.2018 Gazette 2018/26)**

(54) **VERFAHREN UND VORRICHTUNG ZUM MODIFIZIEREN VON ABBILDUNGSEIGENSCHAFTEN EINES OPTISCHEN SYSTEMS FÜR DIE MIKROLITHOGRAPHIE**

METHOD AND DEVICE FOR MODIFYING IMAGING PROPERTIES OF AN OPTICAL SYSTEM FOR MICROLITHOGRAPHY

PROCÉDÉ ET DISPOSITIF DE MODIFICATION DE PROPRIÉTÉS DE REPRÉSENTATION D'UN SYSTÈME OPTIQUE POUR LA MICROLITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2016 DE 102016225899**

(43) Veröffentlichungstag der Anmeldung:
**30.10.2019 Patentblatt 2019/44**

(73) Patentinhaber: **Carl Zeiss SMT GmbH**
**73447 Oberkochen (DE)**

(72) Erfinder:
• **KNOPF, Jochen**
**73434 Aalen (DE)**
• **AWAD, Mohammad**
**73431 Aalen (DE)**

(74) Vertreter: **Frank, Hartmut**
**Bonsmann Bonsmann Frank**
**Patentanwälte**
**Reichspräsidentenstraße 21-25**
**45470 Mülheim a. d. Ruhr (DE)**

(56) Entgegenhaltungen:
**WO-A1-2016/087388    DE-A1-102013 219 986**
**US-A1- 2016 170 311**

**Beschreibung**

HINTERGRUND DER ERFINDUNG

Gebiet der Erfindung

Die Erfindung betrifft ein Verfahren und eine Vorrichtung zum Modifizieren von Abbildungseigenschaften eines optischen Systems für die Mikrolithographie.

Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

Zur Erhöhung der Bildlagegenauigkeit und Bildqualität (sowohl entlang der optischen Achse bzw. in Lichtausbreitungsrichtung als auch in lateraler Richtung bzw. senkrecht zur optischen Achse oder Lichtausbreitungsrichtung) ist es insbesondere bekannt, eines oder mehrere der optischen Elemente (z.B. Spiegel) im optischen System als adaptive bzw. aktuierbare Elemente auszugestalten.

Lediglich beispielhaft ist es etwa bekannt, einen oder mehrere Spiegel im optischen System mit einer Aktuatorschicht aus einem piezoelektrischen Material auszugestalten, wobei über die piezoelektrische Schicht hinweg ein elektrisches Feld mit lokal unterschiedlicher Stärke erzeugt wird mit der Folge, dass sich mit lokaler Verformung der piezoelektrischen Schicht auch das Reflexionsschichtsystem des adaptiven Spiegels verformt. Infolgedessen können durch geeignete Ansteuerung der Elektroden (gegebenenfalls auch zeitlich veränderliche) Abbildungsfehler wenigstens teilweise korrigiert werden. Die Verformung des Reflexionsschichtsystems eines Spiegels oder Aktuierung eines anderen optischen Elements wie z.B. einer Linse kann aber auch generell eingesetzt werden, um den mikrolithographischen Abbildungsprozess weiter zu optimieren.

Um in der Praxis die Oberflächenkrümmung des betreffenden adaptiven optischen Elements möglichst exakt sowie zeitlich stabil einstellen zu können, sind im Stand der Technik unterschiedliche Ansätze bekannt, wobei prinzipiell zwischen einer modellbasierten Steuerung der jeweiligen Aktuatoren des adaptiven Elements und einer auf Messdaten basierenden Regelung der Aktuatoren zu unterscheiden ist.

Bei einem bekannten Ansatz zur Realisierung der modellbasierten Steuerung der Aktuatoren wird ein Modell unter Verwendung expliziter Kenntnisse bzw. Informationen über die Konstruktion sowie typische Materialeigenschaften des betreffenden Elements erzeugt und zur Berechnung der jeweils erzielten Oberflächenkrümmung verwendet, wobei die Ansteuerung der Aktuatoren ohne Kenntnis der tatsächlich erzielten Oberflächenkrümmung - und insbesondere ohne entsprechende Sensorik bzw. ohne ein geschlossenes Regelungssystem - erfolgt.

Bei einer solchen, auf einem expliziten Modell basierten Steuerung kann jedoch in der Praxis - wie im Weiteren noch detaillierter beschrieben - das Problem auftreten, das der Gültigkeit eines der Steuerung zugrundegelegten expliziten Modells bei Vorhandensein spezifischer "einzigartiger" Eigenschaften des konkreten optischen Systems (z.B. ein spezielles Abbildungsverhalten aufgrund individueller Fertigungsfehler) Grenzen gesetzt sind, wobei sich eine diesbezügliche Korrektur bzw. Modellanpassung im Hinblick auf die Vielzahl hierbei gegebenenfalls zu berücksichtigender Einflussgrößen als extrem aufwendig erweisen kann.

Was die alternativ zur vorstehend beschriebenen modellbasierten Steuerung ebenfalls in Betracht kommende Regelung der Aktuatoren auf Basis von Messdaten (z.B. Messungen der tatsächlich erzielten Oberflächenkrümmung des jeweiligen Elements) betrifft, kann insoweit zwar die erzielbare Exaktheit der Oberflächenkrümmung verbessert werden, wobei dies jedoch im Hinblick auf die hierzu erforderlichen optischen Messverfahren u.a. mit einer Erhöhung des konstruktiven Aufwandes einhergehen kann.

WO 2016/087388 A1 offenbart u.a. ein Lithographieverfahren unter Reduzierung von Aberrationen, wobei ein Modifizieren der Abbildungseigenschaften des betreffenden optischen Systems auf Basis eines "temporal aberration model", welches Schätzwerte für die Aberrationen des Projektionsobjektivs liefert, und eines "driver lens model", welches den Zusammenhang zwischen den Einstellungen bzw. Ansteuerungen der optischen Elemente des Projektionsobjektivs und den vom Projektionsobjektiv verursachten Aberrationen betrifft, erfolgt.

US 2016/170311 A1 offenbart u.a. ein Lithographiesystem mit einer über einen "machine learning controller" steuerbaren Projektionsbelichtungsanlage, wobei der controller auf Basis künstlicher Intelligenz (z.B. unter Anwendung eines Algorithmus gemäß dem Konzept neuronaler Netzwerke) arbeiten kann.

DE 10 2013 219 986 A1 offenbart u.a. ein Projektionsbelichtungsverfahren, bei welchem mit einem "lens model" berechnet wird, wie auf Grund einer Messung oder einer Vorhersage die Manipulatoren zur Veränderung der Abbildungseigenschaften nachgestellt werden müssen, wobei entsprechende Steuerungsbefehle an die Manipulatorsteuereinheit zur Erreichung der nötigen Abbildungsspezifikationen übermittelt werden.

Zum weiteren Stand der Technik wird lediglich beispielhaft auf DE 10 2011 005 940 A1 verwiesen.

ZUSAMMENFASSUNG DER ERFINDUNG

Es ist eine Aufgabe der vorliegenden Erfindung, ein Verfahren und eine Vorrichtung zum Modifizieren von Abbildungseigenschaften eines optischen Systems für die Mikrolithographie bereitzustellen, welche bei vergleichsweise geringem Aufwand eine möglichst exakte Modifizierung ermöglichen.

Diese Aufgabe wird durch das Verfahren gemäß den Merkmalen des unabhängigen Patentanspruchs 1 bzw. die Vorrichtung gemäß den Merkmalen des nebengeordneten Patentanspruchs 9 gelöst.

Bei einem erfindungsgemäßen Verfahren zum Modifizieren von Abbildungseigenschaften eines optischen Systems für die Mikrolithographie

- erfolgt die Modifikation der Abbildungseigenschaften über Ansteuerungssignale, welche über wenigstens eine Schnittstelle in das optische System eingekoppelt werden,

- wobei die bei der Ansteuerung für eine gewünschte Modifikation der Abbildungseigenschaften jeweils eingekoppelten Werte dieser Ansteuerungssignale auf Basis eines Modells ermittelt werden,

- wobei dieses Modell dadurch erzeugt wird, dass in einer Lernphase, in welcher die für unterschiedliche Werte der Ansteuerungssignale jeweils erzielte Modifikation der Abbildungseigenschaften ermittelt wird, eine sukzessive individuelle Anpassung des Modells an das optische System erfolgt; und

- wobei die Lernphase ohne Vorgabe expliziter Informationen über interne Wirkmechanismen innerhalb des optischen Systems durchgeführt wird.

Gemäß einer Ausführungsform wird zur Modifikation der Abbildungseigenschaften wenigstens ein Element des optischen Systems aktuiert, wobei diese Aktuierung durch Ansteuerung des wenigstens eines Aktors auf Basis der Ansteuerungssignale erfolgt.

Der Erfindung liegt insbesondere das Konzept zugrunde, ausgehend von dem Prinzip einer modellbasierten Ansteuerung von Aktoren zur Aktuierung eines Elements das hierbei verwendete Modell nicht etwa wie bei dem eingangs beschriebenen herkömmlichen Ansatz unter Verwendung von expliziten Kenntnissen über Konstruktion, Materialeigenschaften etc. des betreffenden Elements zu erzeugen bzw. vorzugeben, sondern vielmehr das Modell bzw. die darin einfließenden Kenntnisse implizit in einer Lernphase durch Training am realen optischen System zu erarbeiten.

Mit anderen Worten verzichtet das erfindungsgemäße Verfahren darauf, Wirkmechanismen bzw. -zusammenhänge für das zu aktuierende Element bzw. das dieses Element enthaltende System von vornherein zu modellieren und in Form eines expliziten Modells der Ansteuerung der Aktoren zugrundezulegen, sondern überlässt es gerade einer Lernphase (entsprechend dem für sich aus der Informatik bekannten Konzept künstlicher Intelligenz bzw. neuronaler Netzwerke), diese Zusammenhänge selbsttätig bzw. automatisch dadurch herauszufinden, dass in dieser Lernphase ermittelt wird, wie das konkrete optische System auf unterschiedliche, zulässige Werte der Ansteuerungssignale bzw. die hierdurch bewirkte Aktuierung des jeweiligen Elements (z.B. die erzielte Oberflächenkrümmung eines adaptiven Spiegels) reagiert.

Dadurch, dass auf eine auf expliziten Kenntnissen der Eigenschaften des konkreten Systems bzw. Elements basierende Vorgabe des Modells verzichtet wird, sind zum einen die zur Erarbeitung solcher expliziten Kenntnisse erforderlichen (z.B. Entwicklungs-) Tätigkeiten entbehrlich, was zu einer signifikanten Ressourceneinsparung führt.

Darüber hinaus besteht ein wesentlicher Vorteil der erfindungsgemäßen Erzeugung des der Steuerung des jeweiligen optischen Elements zugrundegelegten Modells in einer Lernphase am realen optischen System (d.h. der "impliziten Modellierung") darin, dass das hierbei implizit erzeugte Modell bereits optimal auf das konkrete System bzw. das darin verbaute adaptive Element abgestimmt ist, wobei insbesondere etwaige Prozessschwankungen oder Fertigungstoleranzen ohne zusätzlichen Aufwand oder besondere Maßnahmen im Modell automatisch berücksichtigt werden. Im Ergebnis kann so bei vergleichsweise geringem Aufwand eine exaktere Beschreibung bzw. Vorhersage der tatsächlich bewirkten Änderung von Abbildungseigenschaften (z.B. durch Beschreibung der jeweils erzielten Oberflächenkrümmung des Elements) erzielt werden, wobei insbesondere zu keiner Zeit eine Modifikation der Modellstruktur wie in dem zuvor beschriebenen Szenario bei einer explizierten Modellierung erforderlich ist.

Hinzu kommt, dass aufgrund der sich bei dem erfindungsgemäßen Verfahren über eine gewisse (gegebenenfalls längere) Zeitdauer erstreckenden Lernphase dynamische Einflüsse bzw. Drifteffekte automatisch bzw. ohne weitere Maßnahmen in das bei der erfindungsgemäßen impliziten Modellierung erzeugte Modell einfließen und somit ebenfalls automatisch berücksichtigt werden.

Des Weiteren kann in gewissem Rahmen eine Verbesserung der Güte des erfindungsgemäß erzeugten Modells durch Verlängerung der Zeitdauer des Trainings bzw. der Lernphase erzielt werden, was - etwa im Vergleich zu einem erhöhten Entwicklungsaufwand bei der eingangs beschriebenen, herkömmlichen expliziten Modellierung - relativ einfach und kostengünstig umsetzbar ist.

Grundsätzlich ermöglicht die erfindungsgemäße Modellerzeugung auf Basis des aus dem Bereich der Informatik für sich bekannten Ansatzes der künstlichen Intelligenz z.B. in Form eines neuronalen Netzwerks die Errechnung von Vorhersagen auch für bislang noch nicht aufgetretene Situationen mit der Folge, dass eine erhöhte Leistungsfähigkeit der erfindungsgemäßen Steuerung, welche insbesondere sogar an die Leistungsfähigkeit einer Regelung heranreichen kann, erzielt werden kann.

Im Vergleich zu den eingangs beschriebenen Ansätzen einer auf Messdaten basierten Regelung hat das erfindungsgemäße Verfahren insbesondere den Vorteil, dass auf entsprechende optische Messsysteme und den hiermit verbundenen konstruktiven Entwicklungsaufwand verzichtet werden kann.

Im Ergebnis wird somit bei dem erfindungsgemäßen Verfahren einerseits der mit einer auf tatsächlichen Messergebnissen basierenden Regelung einhergehende konstruktive Aufwand vermieden, andererseits aber im Vergleich mit einer expliziten Modellierung eine vergleichsweise exakte Steuerung der Modifikation von Abbildungseigenschaften des optischen Systems, welche näher an die mit Regelungsansätzen erzielbaren Resultate heranreicht, verwirklicht.

Hinsichtlich des durch die erfindungsgemäße implizite Modellierung beschriebenen Verhaltens des konkreten optischen Systems ist die Erfindung nicht auf ein mechanisches Verhalten des Systems beschränkt, sondern auf beliebige Wirkmechanismen einschließlich thermischem Verhalten, Transmissionsverhalten und elektronischem bzw. elektromagnetischem Verhalten anwendbar.

Gemäß einer Ausführungsform wird das Modell unter Verwendung einer Methode der künstlichen Intelligenz erzeugt, wobei in der Lernphase ein Trainieren unter Einkopplung unterschiedlicher Werte der Ansteuerungssignale in das optische System erfolgt.

Gemäß einer Ausführungsform ist die Methode der künstlichen Intelligenz aus der Gruppe ausgewählt, welche Überwachtes Lernen (= "Supervised Learning"), Unüberwachtes Lernen (= "Unsupervised Learning") und Teilüberwachtes Lernen (= "Semi-Supervised Learning") enthält. Dabei kann beispielsweise ein neuronales Netzwerk verwendet werden. Die Erfindung ist jedoch nicht auf die Anwendung einer bestimmten Methode der künstlichen Intelligenz beschränkt, sondern mit einer beliebigen geeigneten Methode realisierbar. In diesem Zusammenhang wird zum Stand der Technik auf Stuart Russell, Peter Norvig: "Artificial Intelligence: A Modern Approach", Verlag Prentice Hall (ISBN-10: 0136042597) verwiesen.

Gemäß einer Ausführungsform erfolgt die Anpassung des Modells an das optische System in der Lernphase ohne Modifikation der Modellstruktur.

Gemäß einer Ausführungsform setzt das Modell ausschließlich von außerhalb des optischen Systems aus beobachtbare Abbildungseigenschaften sowie von außerhalb des optischen Systems aus veränderbare Ansteuerungssignale zueinander in Beziehung.

Gemäß einer Ausführungsform ist das optische Element ein deformierbares optisches Element, insbesondere ein deformierbarer Spiegel.

Gemäß einer Ausführungsform ist das optische System eine mikrolithographische Projektionsbelichtungsanlage, welche eine Beleuchtungseinrichtung und ein Projektionsobjektiv aufweist, wobei die Beleuchtungseinrichtung im Betrieb der Projektionsbelichtungsanlage eine in einer Objektebene des Projektionsobjektivs angeordnete und abzubildende Strukturen aufweisende Maske mit Nutzlicht einer Arbeitswellenlänge beleuchtet und wobei das Projektionsobjektiv diese Strukturen auf ein in einer Bildebene des Projektionsobjektivs angeordnetes Substrat abbildet.

Die Erfindung betrifft weiter eine Vorrichtung zum Modifizieren von Abbildungseigenschaften eines optischen Systems für die Mikrolithographie, welche dazu konfiguriert ist, ein Verfahren mit den vorstehend beschriebenen Merkmalen durchzuführen, sowie eine mit einer solchen Vorrichtung ausgestattete mikrolithographische Projektionsbelichtungsanlage. Zu Vorteilen sowie vorteilhaften Ausgestaltungen der Vorrichtung wird auf die obigen Ausführungen im Zusammenhang mit dem erfindungsgemäßen Verfahren Bezug genommen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

KURZE BESCHREIBUNG DER ZEICHNUNGEN

Es zeigen:

Figur 1 eine schematische Darstellung eines Projektionsobjektivs einer für den Betrieb im EUV-Bereich ausgelegten mikrolithographischen Projektionsbelichtungsanlage, in welcher die Erfindung beispielsweise realisierbar ist;

Figur 2 eine schematische Darstellung eines Projektionsobjektivs einer für den Betrieb im DUV-Bereich ausgelegten mikrolithographischen Projektionsbelichtungsanlage, in welcher die Erfindung realisierbar ist; und

Figuren 3a-e schematische Darstellungen zur Erläuterung einer beispielhaften Anwendung der Erfindung.

DETAILLIERTE BESCHREIBUNG BEVORZUGTER AUSFÜHRUNGSFORMEN

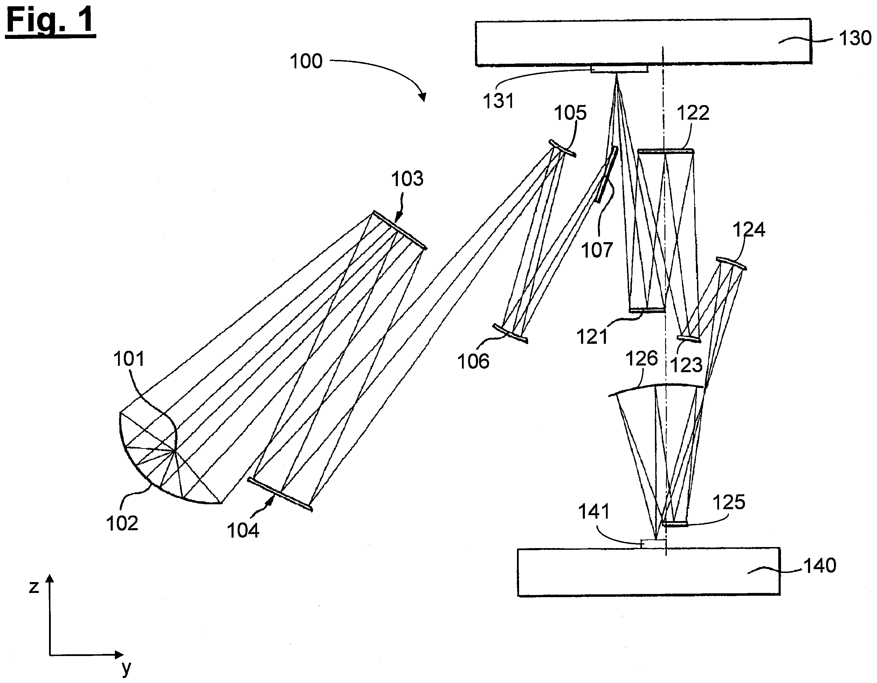

Fig. 1 zeigt zunächst eine schematische Darstellung einer für den Betrieb im EUV ausgelegten Projektionsbelichtungsanlage 100, in welcher die Erfindung beispielsweise realisierbar ist.

Gemäß Fig. 1 weist eine Beleuchtungseinrichtung der Projektionsbelichtungsanlage 100 einen Feldfacettenspiegel 103 und einen Pupillenfacettenspiegel 104 auf. Auf den Feldfacettenspiegel 103 wird das Licht einer Lichtquelleneinheit, welche im Beispiel eine EUV-Lichtquelle (Plasmalichtquelle) 101 und einen Kollektorspiegel 102 umfasst, gelenkt. Im Lichtweg nach dem Pupillenfacettenspiegel 104 sind ein erster Teleskopspiegel 105 und ein zweiter Teleskopspiegel 106 angeordnet. Im Lichtweg nachfolgend ist ein Umlenkspiegel 107 angeordnet, der die auf ihn treffende Strahlung auf ein Objektfeld in der Objektebene eines sechs Spiegel 121-126 umfassenden Projektionsobjektivs lenkt. Am Ort des Objektfeldes ist eine reflektive strukturtragende Maske 131 auf einem Maskentisch 130 angeordnet, die mit Hilfe des Projektionsobjektivs in eine Bildebene abgebildet wird, in welcher sich ein mit einer lichtempfindlichen Schicht (Photoresist) beschichtetes Substrat 141 auf einem Wafertisch 140 befindet.

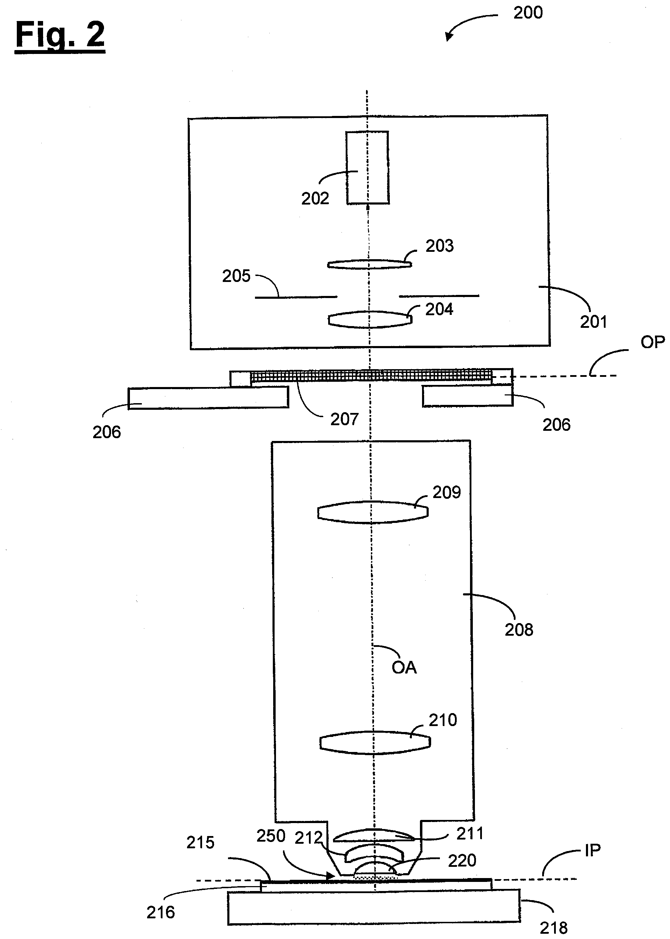

Fig. 2 zeigt eine schematische Darstellung eines weiteren möglichen Aufbaus einer mikrolithographischen Projektionsbelichtungsanlage 200, welche für den Betrieb bei Wellenlängen im DUV-Bereich (z.B. ca. 193nm) ausgelegt ist und ebenfalls eine Beleuchtungseinrichtung 201 und ein Projektionsobjektiv 208 aufweist.

Die Beleuchtungseinrichtung 201 umfasst eine Lichtquelle 202 und eine in stark vereinfachter Weise durch Linsen 203, 204 und eine Blende 205 symbolisierte Beleuchtungsoptik. Die Arbeitswellenlänge der Projektionsbelichtungsanlage 200 beträgt in dem gezeigten Beispiel 193 nm bei Verwendung eines ArF-Excimerlasers als Lichtquelle 202. Die Arbeitswellenlänge kann jedoch beispielsweise auch 248 nm bei Verwendung eines KrF-Excimerlasers oder 157 nm bei Verwendung eines $F_2$-Lasers als Lichtquelle 202 betragen. Zwischen der Beleuchtungseinrichtung 201 und dem Projektionsobjektiv 208 ist eine Maske 207 in der Objektebene OP des Projektionsobjektivs 208 angeordnet, die mittels eines Maskenhalters 206 im Strahlengang gehalten wird. Die Maske 207 weist eine Struktur im Mikrometer- bis Nanometer-Bereich auf, die mittels des Projektionsobjektives 208 beispielsweise um den Faktor 4 oder 5 verkleinert auf eine Bildebene IP des Projektionsobjektivs 208 abgebildet wird. Das Projektionsobjektiv 208 umfasst eine ebenfalls lediglich in stark vereinfachter Weise durch Linsen 209 bis 212 symbolisierte Linsenanordnung, durch die eine optische Achse OA definiert wird. In der Bildebene IP des Projektionsobjektivs 208 wird ein durch einen Substrathalter 218 positioniertes und mit einer lichtempfindlichen Schicht 215 versehenes Substrat 216, bzw. ein Wafer, gehalten. Zwischen dem bildebensei-tig letzten optischen Element 220 des Projektionsobjektivs 208 und der lichtempfindlichen Schicht 215 befindet sich ein Immersionsmedium 250, bei dem es sich beispielsweise um deionisiertes Wasser handeln kann.

Im Betrieb der Projektionsbelichtungsanlage gemäß Fig. 1 oder Fig. 2 können aufgrund unterschiedlicher Ursachen ohne weitere Maßnahmen z.B. thermisch bedingte Abbildungsfehler auftreten. Zur Korrektur solcher Abbildungsfehler oder generell zur Optimierung der optischen Eigenschaften können in der jeweiligen Projektionsbelichtungsanlage eines oder mehrere der optischen Elemente (z.B. Spiegel) als adaptive bzw. aktuierbare Elemente ausgestaltet sein.

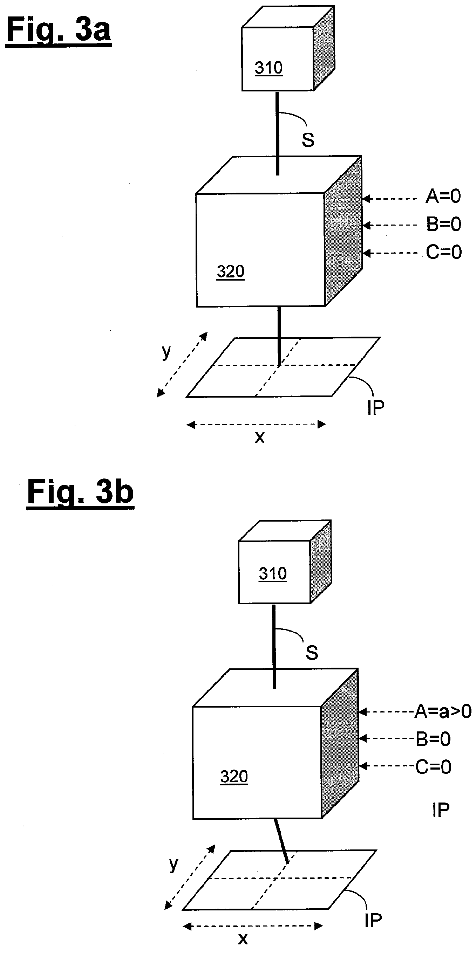

Hiervon ausgehend wird im Folgenden unter Bezugnahme auf Fig. 3a-e ein beispielhafter Anwendungsfall der vorliegenden Erfindung erläutert. Dieser Anwendungsfall besteht darin, dass ein im Betrieb einer Projektionsbelichtungsanlage z.B. gemäß Fig. 1 oder Fig. 2 das jeweilige (in Fig. 3a-e mit "320" bezeichnete) Projektionsobjektiv durchlaufender und von einer Lichtquelle bzw. Beleuchtungseinrichtung 310 ausgehender Lichtstrahl S (bzw. dessen in der x-bzw. y-Richtung) hinsichtlich der x-y-Koordinaten des Einfallpunkts in der Bildebene IP über Ansteuerungssignale A bzw. B, und hinsichtlich des Durchmessers über ein weiteres Steuersignal C, manipuliert werden kann. Ein Bildpunkt p kann hierbei beschrieben werden als p := [x,y,d], wobei x die Bildpunktkoordinate in x-Richtung, y die Bildpunktkoordinate in y-Richtung und d den Durchmesser des Bildpunkts angibt.

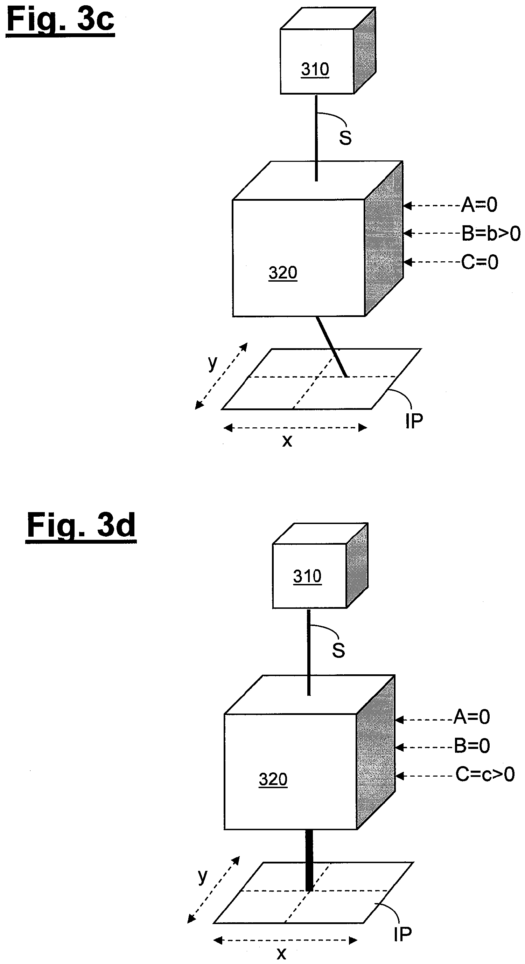

Die Ansteuerungssignale A, B und C werden dem Projektionsobjektiv über entsprechende Steuereingänge (welche lediglich beispielhaft als numerische Schnittstellen ausgestaltet sein können) zugeführt. In den schematischen Darstellungen veranschaulicht Fig. 3b die Manipulation des Einfallpunktes des Lichtstrahls S in der Bildebene IP in y-Richtung über das Steuersignal A, Fig. 3c veranschaulicht die Manipulation des Einfallpunktes des Lichtstrahls S in der Bildebene IP in x-Richtung über das Steuersignal B, und Fig. 3d veranschaulicht die Manipulation des Durchmessers des Lichtstrahls S in der Bildebene IP über das Steuersignal C.

Lediglich beispielhaft (und ohne dass die Erfindung hierauf beschränkt wäre) kann durch die besagten Ansteuerungssignale etwa ein im Projektionsobjektiv vorhandener, deformierbarer Spiegel angesteuert werden, um die Oberflächenkrümmung des Spiegels zwecks Modifikation der Abbildungseigenschaften des Projektionsobjektivs (etwa zur Kompensation einer im System vorhandenen Störung) zu verändern.

Im Weiteren wird nun davon ausgegangen, dass die entsprechenden Aktuatoren zur Deformation dieses Spiegels während des mikrolithographischen Belichtungsprozesses auf Basis eines Modells angesteuert werden sollen, welches letztlich den Zusammenhang zwischen dem erzeugten Bildpunkt (definiert über x- bzw. y-Koordinate sowie Durchmesser d des Lichtstrahls S) und den Ansteuerungssignalen A, B und C beschreibt, mit anderen Worten also die Reaktion des Projektionsobjektivs 320 auf bestimmte Werte der Ansteuerungssignale A, B und C angibt.

Gemäß der vorliegenden Erfindung wird nun dieses benötigte Modell nicht explizit vorgegeben, sondern vielmehr implizit im Wege einer Lernphase bzw. eines Trainings am realen System bzw. Projektionsobjektiv "erarbeitet".

Im Rahmen einer - erfindungsgemäß vermiedenen - expliziten Modellierung könnte etwa für den Zusammenhang zwischen dem Bildpunkt p=[x,y,d] und den Ansteuerungssignalen A, B und C ein explizites Modell wie folgt zugrundegelegt werden:

$$[x,y,d] = f(A,B,C) = [A,B,C] \qquad (1)$$

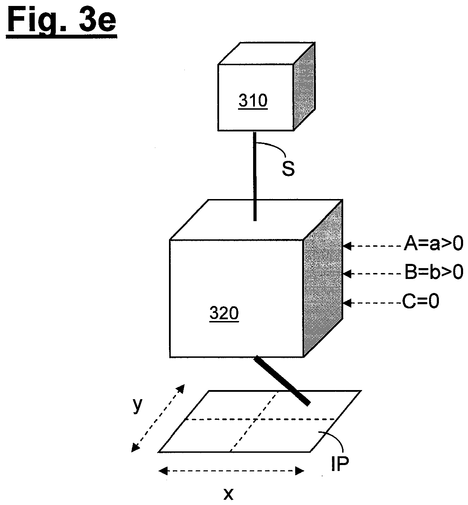

Allerdings ist die explizite Modellierung gemäß (1) bereits nicht zur Beschreibung eines komplexeren Zusammenhangs geeignet, welcher sich beispielsweise ergibt, wenn das betreffende reale System bzw. das Projektionsobjektiv 320 etwa aufgrund von Fertigungsfehlern, ungünstigen Toleranzsituationen etc. bestimmte "einzigartige Eigenschaften" aufweist mit der Folge, dass der Durchmesser d des in der Bildebene IP erzeugten Bildpunkts nicht allein durch das Steuersignal C, sondern auch zusätzlich über die Ansteuerungssignale A und B beeinflusst wird. Ein solches Szenario ist veranschaulicht in Fig. 3e, wo sich - trotz eines Wertes C=0 für das zur Manipulation des Durchmessers des Lichtstrahls IP bestimmte Steuersignal C bei Werten ungleich Null für die Ansteuerungssignale A, B - der Durchmesser des Lichtstrahls S in der Bildebene IP ändert.

Eine Berücksichtigung des vorstehend beschriebenen Szenarios würde bei expliziter Modellierung eine Anpassung der Struktur des Modells, z.B. gemäß

$$f(A,B,C) = [A, B, g(A,B,C)] \qquad (2)$$

erfordern. Zur Ermittlung des Durchmessers des Bildpunkts sind in diesem Falle somit nicht nur das Steuersignal C, sondern zusätzlich noch Informationen über die Ansteuerungssignale A und B erforderlich. Dies wiederum kann einen erheblichen Aufwand bedeuten, da in der Praxis jedes denkbare Verhalten des realen Systems bzw. Projektionsobjektivs in Abhängigkeit von sämtlichen denkbaren Einflussgrößen angegeben werden müsste.

Durch die erfindungsgemäße implizite Modellierung kann nun insbesondere dem vorstehend beschriebenen Problem Rechnung getragen werden. Dabei unterscheidet sich die erfindungsgemäße "implizite Modellierung" von der vorstehend beschriebenen "expliziten Modellierung" dadurch, dass anstelle der Vorgabe einer formellen Beschreibung des Objektivverhaltens zunächst mit einem "leeren" (d.h. nicht weiter spezifizierten bzw. vorgegebenen) Modell gestartet wird, wobei lediglich jeweils zulässige Eingabewerte für die Steuergrößen A, B und C definiert werden und hierzu das entsprechende Verhalten des realen Systems bzw. Projektionsobjektivs anhand der jeweiligen Ergebnisse für x, y und d (d. h. die x- bzw. y-Koordinaten sowie den Durchmesser d des in der Bildebene IP erzeugten Bildpunkts) bewertet wird.

Dieser Start mit einem "leeren", nicht weiter spezifizierten bzw. vorgegebenen Modell kann geschrieben werden als

$$[x,y,d] = h(A,B,C) = ? \qquad (3)$$

Der Aufbau des Modells erfolgt dann im Wege einer Lernphase bzw. über ein Training am realen System bzw. Projektionsobjektiv, indem für unterschiedliche Kombinationen zulässiger Eingabewerte für die Steuergrößen A, B und C die sich jeweils mit dem realen System einstellenden Ergebnisse für x, y und d ermittelt werden. Hierzu kann in der Bildebene IP ein z.B. kamerabasierter Detektor(z.B. CCD-Kamera) zur ortsaufgelösten Bestimmung der Lichtintensität platziert werden.

In einem einfachen Fall könnten sämtliche Kombinationen zulässiger Eingabewerte für die Steuergrößen A, B und C vorab "ausprobiert" und jeweils die sich einstellenden Ergebnisse für x, y und d ermittelt werden, woraufhin im Ergebnis eine dreidimensionale Tabelle erhalten wird, welche das gewünschte implizite Modell darstellt. Wenn nun im anschließend durchgeführten, eigentlichen Lithographieprozess eine bestimmte Wertekombination [x,y,d] gewünscht wird, kann die hierzu geeignete Wahl der Steuergrößen A, B und C aus der betreffenden Tabelle bzw. dem Modell abgelesen werden.

Ein effizienter Aufbau des impliziten Modells kann mit Methoden der künstlichen Intelligenz erfolgen. Das erfindungsgemäße Verfahren hat hierbei den Vorteil, dass das Modell während der Lernphase jeweils unter automatischer Anpassung an das reale System bzw. Projektionsobjektiv aufgebaut wird, wobei insbesondere zu keiner Zeit eine Modifikation der Modellstruktur wie in dem zuvor beschriebenen Szenario bei explizierter Modellierung erforderlich ist. Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

**Patentansprüche**

1.  Verfahren zum Modifizieren von Abbildungseigenschaften eines optischen Systems für die Mikrolithographie,

    • wobei die Modifikation der Abbildungseigenschaften über Ansteuerungssignale (A, B, C) erfolgt, welche über wenigstens eine Schnittstelle in das optische System eingekoppelt werden;
    • wobei die bei der Ansteuerung für eine gewünschte Modifikation der Abbildungseigenschaften jeweils eingekoppelten Werte dieser Ansteuerungssignale auf Basis eines Modells ermittelt werden;
    • wobei dieses Modell dadurch erzeugt wird, dass in einer Lernphase, in welcher die für unterschiedliche Werte der Ansteuerungssignale jeweils erzielte Modifikation der Abbildungseigenschaften ermittelt wird, eine sukzessive individuelle Anpassung des Modells an das optische System erfolgt; und
    • wobei die Lernphase ohne Vorgabe expliziter Informationen über interne Wirkmechanismen innerhalb des optischen Systems durchgeführt wird.

2.  Verfahren nach Anspruch 1, **dadurch gekennzeichnet, dass** das Modell unter Verwendung einer Methode der künstlichen Intelligenz erzeugt wird, wobei in der Lernphase ein Trainieren unter Einkopplung unterschiedlicher Werte der Ansteuerungssignale in das optische System erfolgt.

3.  Verfahren nach Anspruch 2, **dadurch gekennzeichnet, dass** die Methode der künstlichen Intelligenz aus der Gruppe ausgewählt ist, welche Überwachtes Lernen (= "Supervised Learning"), Unüberwachtes Lernen (= "Unsupervised Learning") und Teilüberwachtes Lernen (= "Semi-Supervised Learning") enthält.

4.  Verfahren nach einem der vorhergehenden Ansprüche, **dadurch gekennzeichnet, dass** die Anpassung des Modells an das optische System in der Lernphase ohne Modifikation der Modellstruktur erfolgt.

5.  Verfahren nach einem der vorhergehenden Ansprüche, **dadurch gekennzeichnet, dass** das Modell ausschließlich von außerhalb des optischen Systems aus beobachtbare Abbildungseigenschaften sowie von außerhalb des optischen Systems aus veränderbare Ansteuerungssignale zueinander in Beziehung setzt.

6.  Verfahren nach einem der vorhergehenden Ansprüche, **dadurch gekennzeichnet, dass** zur Modifikation der Abbildungseigenschaften wenigstens ein Element des optischen Systems aktuiert wird, wobei diese Aktuierung durch Ansteuerung des wenigstens eines Aktors auf Basis der Ansteuerungssignale (A, B, C) erfolgt.

7.  Verfahren nach Anspruch 6, **dadurch gekennzeichnet, dass** das optische Element ein deformierbares optisches Element, insbesondere ein deformierbarer Spiegel, ist.

8.  Verfahren nach einem der vorhergehenden Ansprüche, **dadurch gekennzeichnet, dass** das optische System eine mikrolithographische Projektionsbelichtungsanlage ist, welche eine Beleuchtungseinrichtung und ein Projektionsobjektiv aufweist, wobei die Beleuchtungseinrichtung im Betrieb der Projektionsbelichtungsanlage eine in einer Objektebene des Projektionsobjektivs angeordnete und abzubildende Strukturen aufweisende Maske mit Nutzlicht einer Arbeitswellenlänge beleuchtet und wobei das Projektionsobjektiv diese Strukturen auf ein in einer Bildebene des Projektionsobjektivs angeordnetes Substrat abbildet.

9.  Vorrichtung zum Modifizieren von Abbildungseigenschaften eines optischen Systems für die Mikrolithographie, **dadurch gekennzeichnet, dass** die Vorrichtung dazu konfiguriert ist, ein Verfahren nach einem der vorhergehenden Ansprüche durchzuführen.

10. Mikrolithographische Projektionsbelichtungsanlage, **dadurch gekennzeichnet, dass** diese eine Vorrichtung nach Anspruch 9 aufweist.


**Claims**

1.  Method for modifying imaging properties of a microlithographic optical system,

    • wherein the imaging properties are modified by way of control signals (A, B, C) that are coupled into the optical system by way of at least one interface;
    • wherein the values of said control signals that are in each case coupled in during the controlling for a desired modification of the imaging properties are ascertained on the basis of a model;
    • wherein said model is created by virtue of performing, in a learning phase in which the modification of the imaging properties that is in each case attained for different values of the control signals is ascertained, a successive individual adaptation of the model to the optical system; and
    • wherein the learning phase is performed without prior specification of explicit information relating to internal mechanisms of action within the optical system.

2. Method according to Claim 1, **characterized in that** the model is created using a method of artificial intelligence, wherein training with coupling of different values of the control signals into the optical system is performed in the learning phase.

3. Method according to Claim 2, **characterized in that** the method of artificial intelligence is selected from the group including supervised learning, unsupervised learning, and semi-supervised learning.

4. Method according to one of the preceding claims, **characterized in that** the model is adapted to the optical system in the learning phase without modification of the model structure.

5. Method according to one of the preceding claims, **characterized in that** the model correlates only imaging properties that are observable from outside the optical system with control signals that are variable from outside the optical system.

6. Method according to one of the preceding claims, **characterized in that** at least one element of the optical system is actuated for modifying the imaging properties, wherein said actuation is effected by controlling the at least one actuator on the basis of the control signals (A, B, C).

7. Method according to Claim 6, **characterized in that** the optical element is a deformable optical element, in particular a deformable mirror.

8. Method according to one of the preceding claims, **characterized in that** the optical system is a microlithographic projection exposure apparatus, comprising an illumination device and a projection lens, wherein the illumination device illuminates a mask having structures to be imaged that are arranged in an object plane of the projection lens with used light having an operating wavelength during the operation of the projection exposure apparatus and wherein the projection lens images said structures onto a substrate arranged in an image plane of the projection lens.

9. Apparatus for modifying imaging properties of a microlithographic optical system, **characterized in that** the apparatus is configured to carry out a method according to one of the preceding claims.

10. Microlithographic projection exposure apparatus, **characterized in that** it comprises an apparatus according to Claim 9.

## Revendications

1. Procédé de modification de propriétés de reproduction d'un système optique destiné à la microlithographie,

   • la modification des propriétés de reproduction étant effectuée par le biais de signaux de commande (A, B, C) qui sont injectés par couplage dans le système optique par le biais d'au moins une interface ;
   • les valeurs de ces signaux de commande, injectées par couplage lors de la commande d'une modification souhaitée des propriétés de reproduction, étant déterminées sur la base d'un modèle ;
   • ce modèle étant généré par une adaptation individuelle successive du modèle au système optique effectuée dans une phase d'apprentissage au cours de laquelle est déterminée la modification des propriétés de reproduction qui est obtenue pour différentes valeurs des signaux de commande ; et
   • la phase d'apprentissage étant réalisée sans spécifier d'informations explicites sur les mécanismes d'action internes au système optique.

2. Procédé selon la revendication 1, **caractérisé en ce que** le modèle est généré à l'aide d'une méthode d'intelligence artificielle, un apprentissage étant effectué dans la phase d'apprentissage par injection par couplage de différentes valeurs des signaux de commande dans le système optique.

3. Procédé selon la revendication 2, **caractérisé en ce que** la méthode d'intelligence artificielle est choisie dans le groupe comprenant l'apprentissage supervisé (= "supervised learning"), l'apprentissage non supervisé (= "unsupervised learning"), et l'apprentissage partiellement supervisé (= "semi-supervised learning").

4. Procédé selon l'une des revendications précédentes, **caractérisé en ce que** l'adaptation du modèle au système optique est effectuée dans la phase d'apprentissage sans modification de la structure de modèle.

5. Procédé selon l'une des revendications précédentes, **caractérisé en ce que** le modèle ne concerne que des propriétés de reproduction observables de l'extérieur du système optique et des signaux de commande variables de l'extérieur du système optique.

6. Procédé selon l'une des revendications précédentes, **caractérisé en ce qu'**au moins un élément du système optique est actionné pour modifier les propriétés de reproduction, cet actionnement étant effectué par commande de l'au moins un actionneur sur la base des signaux de commande (A, B, C).

7. Procédé selon la revendication 6, **caractérisé en ce que** l'élément optique est un élément optique déformable, notamment un miroir déformable.

8. Procédé selon l'une des revendications précédentes, **caractérisé en ce que** le système optique est une installation d'éclairage et de projection microlithographique qui comporte un moyen d'éclairage et un objectif de projection, le moyen d'éclairage éclairant, pendant le fonctionnement de l'installation d'éclairage et de projection, un masque qui comporte des structures à reproduire disposées dans un plan objet de l'objectif de projection avec une lumière utile d'une longueur d'onde de travail et l'objectif de projection reproduisant ces structures sur un substrat disposé dans un plan image de l'objectif de projection.

9. Dispositif de modification de propriétés de reproduction d'un système optique destiné à la microlithographie,
**caractérisé en ce que**
le dispositif est conçu pour mettre en œuvre un procédé selon l'une des revendications précédentes.

10. Système d'éclairage et de projection microlithographique, **caractérisé en ce qu'**il comporte un dispositif selon la revendication 9.

**Fig. 1**

100

130

131

105

122

103

107

124

101

106

121

126

123

102

104

141

125

140

z

y

EP 3 559 750 B1

## Fig. 2

## Fig. 3a

## Fig. 3b

# Fig. 3c

A=0
B=b>0
C=0

# Fig. 3d

A=0
B=0
C=c>0

# Fig. 3e

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016087388 A1
- US 2016170311 A1
- DE 102013219986 A1
- DE 102011005940 A1

**In der Beschreibung aufgeführte Nicht-Patentliteratur**

- Zusammenhang wird zum Stand der Technik. **STUART RUSSELL ; PETER NORVIG.** Artificial Intelligence: A Modern Approach. Verlag Prentice Hall